# EUROPEAN PATENT APPLICATION

(11) **EP 3 205 442 A1**
(43) Date of publication of application: **16.08.2017**
(21) Application number: 16155430.8
(22) Date of filing: 12.02.2016
(51) Int. Cl.: B23P 15/02, F01D 5/28, F01D 5/14, B22F 3/105, B22F 5/04, B22F 7/06, B22F 7/08

(54) **GAS TURBINE BLADE AND METHOD OF MANUFACTURING THE SAME**

(71) Applicant: Siemens Aktiengesellschaft, 80333 München (DE)
(72) Inventor: Marchant, Geoffrey, Lincoln, LN6 9SY (GB)
(74) Representative: Maier, Daniel Oliver

(57) **Abstract**

The invention provides a method of manufacturing a gas turbine blade (38) having an airfoil (58) and a root (59). According to the invention the method includes a step of casting the airfoil (58) and a step of building the root (59) on the cast airfoil (58) using selective laser melting (SLM). The selective laser melting includes depositing layers of a powder and selectively melting each layer. The airfoil (58) is cast from a first nickel superalloy having a first chromium content while the powder used in the selective laser melting process consists of a second nickel superalloy having a second chromium content higher than the first chromium content.

The invention further provides a gas turbine blade (38) comprising a cast airfoil (58) and a root (59) as obtained by or obtainable by the method of the invention.

## Description

### Field of Technology

The invention relates to a method of manufacturing a gas turbine blade and a gas turbine blade that may be manufactured using the method of the invention.

### Technical Background

Stationary gas turbines are used to drive electric generators. Fuel is combusted and produces hot gases that drive the gas turbine by streaming across several rows of gas turbine blades. The hot gas rotates the gas turbine which drives the electric generator and a compressor for compressing the combustion air.

Gas turbines reach very high speeds causing high mechanical stress to the components of the gas turbine. Gas turbine blades have to expose superior creep and fatigue properties which necessitate complex casting techniques and special materials such as nickel superalloys. The corrosive nature of the hot gas adds to the stress on the gas turbine blades. However, materials with a low creep tendency are commonly prone to corrosion which is why protective coatings using ceramic materials need to be applied. Such ceramic coatings are expensive and difficult to apply consistently, especially in the root portion of the turbine blade.

It is therefore an object of the invention to provide improved methods of manufacturing a gas turbine blade.

Furthermore, it is an object invention to provide an improved gas turbine blade.

### Summary of the Invention

For this reason the invention provides a method of manufacturing a gas turbine blade having an airfoil and a root. According to the invention the method includes a step of casting the airfoil and a step of building the root on the cast airfoil using selective laser melting (SLM). The selective laser melting includes depositing layers of a powder and selectively melting each layer. The airfoil is cast from a first nickel superalloy having a first chromium content while the powder used in the selective laser melting process consists of a second nickel superalloy having a second chromium content higher than the first chromium content.

The method of the invention makes it possible to produce gas turbine blades that have superior creep resistance in the airfoil portion due to the relatively low chromium content of the airfoil. At the same time the gas turbine blades produced with the method of the invention show good corrosion resistance without the need of protective coatings in the root portion of the gas turbine blade due to the relatively high chromium content in the root portion. Ceramic coatings are particularly difficult to apply in the curved root section of a gas turbine blade and are prone to cracking and scratching due to the mechanic stress that occurs in this part of the air turbine blade e.g. when inserted into the corresponding disc on the gas turbine shaft.

Such an improved gas turbine blade cannot be produced using conventional manufacturing techniques e.g. by casting the airfoil and the root of the gas turbine blade separately from different materials and welding them together as this would result in a weak joint such that the component would not meet its required design life.

Using casting from a low-chromium alloy will produce an airfoil having desirable creep strength. The root including the extended root section and root fixings are then built directly on the cast airfoil using the selective laser melting process and a high-chromium alloy. Preferably an equiaxed alloy will be used for the SLM process. The SLM process is known to produce extremely fine grained microstructures that give excellent tensile and fatigue properties which are of great benefit in the root section of the gas turbine blade. The invention thus makes is possible to select a high creep strength alloy for the airfoil and a high fatigue strength alloy (showing good corrosion resistance) in the root section of the gas turbine blade.

The step of casting the airfoil may include casting an equiaxed, directionally solidified or single crystal airfoil. Any traditional turbine blade alloy may be used in the casting process, e.g. MarM247, CM247 as equiaxed grain or directionally solidified casting or CMSX4, CMSX8 etc. for single crystal casting.

The method of the invention may further include a step of machining the root of the gas turbine blade to remove excess material. The SLM process may be carried out to result in a turbine component slightly bigger than the desired final geometry as the production from a powder stock generally results in a rough surface which then can be machined to a smooth surface having the desired geometry.

The selective laser melting may further include blending the first nickel superalloy and the second nickel superalloy and increasing a fraction of the second nickel superalloy in the blend while building the root. This allows for gradually increasing the chromium content in a transition region and improves interfacing between the two superalloy materials. The blending may be carried out by providing respective powders from separate powder stocks and powder dispensers increasing the relative amount of the second superalloy while the number of deposited layers increases.

Casting the airfoil may include casting a root platform. The root platform is preferably cast together with the airfoil. At the same time building the root may include building an extended root and a root fixing on the cast root platform. This means that the root platform may not be considered part of the root of the gas turbine blade but rather of the airfoil in the meaning of the present disclosure.

In particular a portion of the root between the root platform and the extended root may be built from the blend of the first and the second nickel superalloys while the extended root and the root fixing may be built from the second nickel superalloy. That is, the transition region may be the portion of the root between the root platform (belonging to the cast section of the gas turbine blade) and the extended root section of the root of the gas turbine blade. The remaining parts of the root section may then be built exclusively from the second superalloy.

A second aspect of the invention provides a gas turbine blade comprising a cast airfoil and a root as obtained by or obtainable by the method of the first inventive aspect. The airfoil (not including any coatings) consists of a first nickel superalloy having a first chromium content. The root consists of a plurality of layers deposited and melted in a selective laser melting process and comprises a second nickel superalloy having a second chromium content higher than the first chromium content.

Generally the first chromium content may be lower than 9 wt%. For example it may be between 4 and 9 wt%. The second chromium content may be at least 12 wt%. For example it may be between 12 and 23 wt%.

The first superalloy may have a chromium content between 4 and 9 wt%, aluminum between 3 and 7 wt%, up to 4% titanium, tantalum between 3 and 7 wt%, tungsten from 4 to 10 wt%, rhenium from 2 to 4 wt%, up to 1 wt% molybdenum and 6 to 12 wt% cobalt with the balance being nickel. Carbon and boron may be added in directionally solidified materials to a content of up to 0.2 wt% and 0.03 wt%, respectively. However, for single crystal alloys these two elements should be tightly controlled to remain below 0.01 wt% maximum in order to avoid formation of carbide/boride strengthening phases. For good weldability and good interfacing to the SLM root of the gas turbine blade carbide and boron should remain below 0.01 wt% and nitrogen should be restricted to a maximum of 0.001 wt%.

Two possible candidates for the first superalloy are CM247DS and CMSX4. CM247DS is a suitable nickel balance superalloy having a composition of 8..8.5 wt% Cr, 9..9.5 wt% Co, 0.6..0.9 wt% Ti, 5.45..5.75 wt% Al, 9.3..9.7 wt% W, 3.1..3.3 wt% Ta, 0.07..0.08 wt% C, 1.2..1.6 wt% Hf, 0.005..0.02 wt% Zr, 0.01..0.02 wt% B, 0.4..0.6 wt% Mo. Furthermore up to 0.005 wt% N, up to 0.03 wt% Si, up to 0.005 wt% Cu, up to 0.0001 wt% Bi, up to 0.0005 Se, up to 0.0005 wt% Ag, up to 0.0005 wt% Pb, up to 0.1 wt% V, up to 0.0005 wt% S, up to 0.0025 wt% 0, up to 0.5 wt% Fe, up to 0.005 wt% P and up to 0.0015 wt% Ga may be present.

CMSX4 is another suitable nickel balance superalloy having a composition of 6.2..6.6 wt% Cr, 9.3..10 wt% Co, 0.9..1.1 wt% Ti and 5.45..5.75 wt% Al with the total content of Ti and Al being between 6.35..6.85 wt%, 6.2..6.6 wt% W, 6.3..6.7 wt% Ta, 0.07..0.12 wt% Hf, 0.5..0.7 wt% Mo and 2.8..3.1 wt% Re. Furthermore up to 0.1 wt% Nb, up to 0.01 wt% C, up to 0.0075 wt% Zr, up to 0.0025 wt% B, up to 0.001 wt% N, up to 0.04 wt% Si, up to 0.005 wt% Cu, up to 0.00002 wt% Bi, up to 0.00005 wt% Se, up to 0.0002 wt% Ag, up to 0.0002 wt% Pb, up to 0.01 wt% Mn, up to 0.0005 wt% S, up to 0.001 wt% 0, up to 0.15 wt% Fe, up to 0.003 wt% P, up to 0.0015 wt% Ga, up to 0.00002 wt% Te, up to 0.0002 wt% As, up to 0.008 wt% Mg, up to 0.00003 wt% Tl, up to 0.0002 wt% Cd, up to 0.0002 wt% In, up to 0.0002 wt% Sb and up to 0.0005 wt% Zn may be present.

The second superalloy may comprise from 12 to 23 wt% chromium, 8 to 20 wt% cobalt, 1 to 6 wt% aluminum, up to 5 wt% titanium, 1 to 3 wt% tantalum, 1 to 4 wt% tungsten, 1 to 4 wt% molybdenum and up to 2 wt% niobium. Addition of up to 0.25 wt% carbon and up to 0.025 wt% boron may be made to facilitate carbide/boride strengthening phases in the material. In order to ensure good weldability of the second superalloy carbon and boron as well as zirconium (below 0.03 wt%) should be tightly controlled.

The second superalloy for the root could be one of IN939 or IN738LC. IN939 is a nickel balance superalloy having a composition of 22..22.8 wt% Cr, 18.5..19.5 wt% Co, 3.6..3. Ti, 1.8..2.2 wt% W, 1.8..2.0 wt% Al, 0.9..1.1 wt% Nb, 1.3..1.5 Ta, 0.13..0.17 wt% C, 0.02..0.03 wt% Zr and 0.004..0.006 wt% B. It may further comprise up to 0.5 wt% Fe, up to 0.2 wt% Si, up to 0.2 wt% Mn, up to 0.005 wt% S, up to 0.005 wt% N, up to 0.002 wt% 0, up to 0.0005 wt% Ag, up to 0.0005 wt% Se, up to 0.00005 wt% Bi, and up to 0.00005 wt% Pb. IN738LC is another nickel balance superalloy having a composition of 15.7..16.3 wt% Cr, 8..9 wt% Co, 3.2..3.7 wt% Al and 3.2..3.7 wt% Ti with a total content of Al and Ti of 6.5..7.2, 2.4..2.8 wt% W, 1.5..2 wt% Ta, 1.5..2 wt% Mo, 0.6..1.1 wt% Nb, 0.03..0.08 wt% Zr, 0.09..0.13 wt% C and 0.007..0.012 wt% B. It may further comprise up to 0.3 wt% Si, up to 0.2 wt% Mn, up to 0.015 wt% S, up to 0.015 wt% P, up to 0.1 wt% Cu and up to 0.5 wt% Fe.

Preferably a radius of curvature reaches a minimum when crossing a transition region from the cast airfoil to the root of the gas turbine blade. This means that the transition from the cast section of the gas turbine blade to the SLM processed root should be in a region where the curvature of the surface is low because regions with high curvature such as the transition from the airfoil to the root platform or at the root fixings. The curvature is especially low if the shape of the cross section of the root is substantially constant along a length axis of the blade running through the airfoil and the root. The geometry of the gas turbine blade may be adapted to the novel method of manufacturing in order to provide a region close to and below the root platform with little curvature where the transition from the cast airfoil section to the SLM processed root can be made. It is desirable, though, to keep the transition close to the root platform in order to protect as large a portion of the root from corrosion due to the relatively higher chromium content of the second superalloy.

### Brief Description of the Drawings

The above mentioned attributes and other features and advantages of this invention and the manner of attaining them will become more apparent and the invention itself will be better understood by reference to the following description of embodiments of the invention taken in conjunction with the accompanying drawings, wherein
Fig. 1 shows part of a turbine engine in a sectional view and in which the present inventive transition duct is incorporated,
Fig.2 shows a gas turbine blade according to the invention, and
Fig. 3 shows a detailed view of the gas turbine blade of Fig. 2.

### Detailed Description of the Drawings

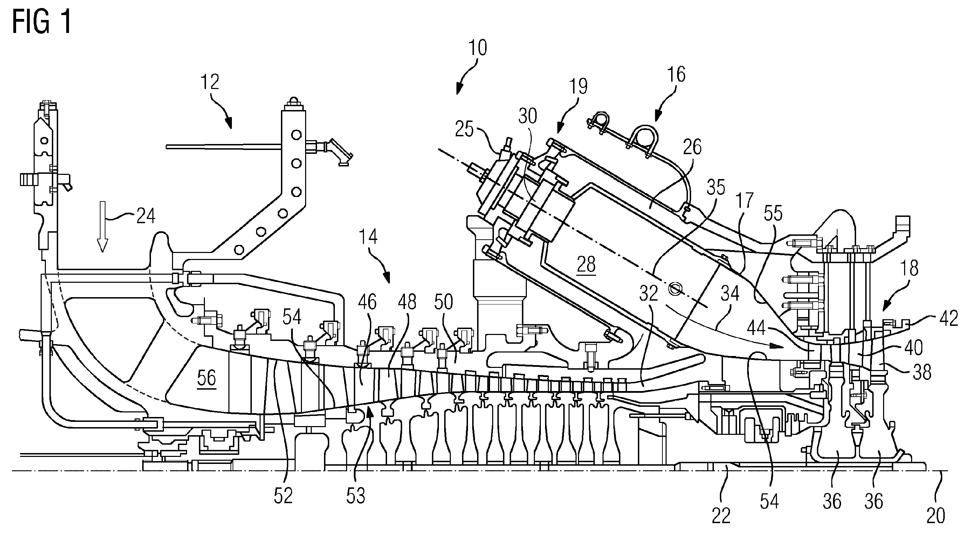

FIG. 1 shows an example of a gas turbine engine 10 in a sectional view. The gas turbine engine 10 comprises, in flow series, an inlet 12, a compressor section 14, a combustor section 16 and a turbine section 18 which are generally arranged in flow series and generally about and in the direction of a longitudinal or rotational axis 20. The gas turbine engine 10 further comprises a shaft 22 which is rotatable about the rotational axis 20 and which extends longitudinally through the gas turbine engine 10. The shaft 22 drivingly connects the turbine section 18 to the compressor section 14.

In operation of the gas turbine engine 10, air 24, which is taken in through the air inlet 12 is compressed by the compressor section 14 and delivered to the combustion section or burner section 16. The burner section 16 comprises a burner plenum 26, one or more combustion chambers 28 and at least one burner 30 fixed to each combustion chamber 28. The combustion chambers 28 and the burners 30 are located inside the burner plenum 26. The compressed air passing through the compressor 14 enters a diffuser 32 and is discharged from the diffuser 32 into the burner plenum 26 from where a portion of the air enters the burner 30 and is mixed with a gaseous or liquid fuel. The air/fuel mixture is then burned and the combustion gas 34 or working gas from the combustion is channelled through the combustion chamber 28 to the turbine section 18 via a transition duct 17.

This exemplary gas turbine engine 10 has a cannular combustor section arrangement 16, which is constituted by an annular array of combustor cans 19 each having the burner 30 and the combustion chamber 28, the transition duct 17 has a generally circular inlet that interfaces with the combustor chamber 28 and an outlet in the form of an annular segment. An annular array of transition duct outlets form an annulus for channelling the combustion gases to the turbine 18.

The turbine section 18 comprises a number of blade carrying discs 36 attached to the shaft 22. In the present example, two discs 36 each carry an annular array of turbine blades 38. However, the number of blade carrying discs could be different, i.e. only one disc or more than two discs. In addition, guiding vanes 40, which are fixed to a stator 42 of the gas turbine engine 10, are disposed between the stages of annular arrays of turbine blades 38. Between the exit of the combustion chamber 28 and the leading turbine blades 38 inlet guiding vanes 44 are provided and turn the flow of working gas onto the turbine blades 38.

The combustion gas from the combustion chamber 28 enters the turbine section 18 and drives the turbine blades 38 which in turn rotate the shaft 22. The guiding vanes 40, 44 serve to optimise the angle of the combustion or working gas on the turbine blades 38.

The turbine section 18 drives the compressor section 14. The compressor section 14 comprises an axial series of vane stages 46 and rotor blade stages 48. The rotor blade stages 48 comprise a rotor disc supporting an annular array of blades. The compressor section 14 also comprises a casing 50 that surrounds the rotor stages and supports the vane stages 48. The guide vane stages include an annular array of radially extending vanes that are mounted to the casing 50. The vanes are provided to present gas flow at an optimal angle for the blades at a given engine operational point. Some of the guide vane stages have variable vanes, where the angle of the vanes, about their own longitudinal axis, can be adjusted for angle according to air flow characteristics that can occur at different engine operations conditions.

The casing 50 defines a radially outer surface 52 of the passage 56 of the compressor 14. A radially inner surface 54 of the passage 56 is at least partly defined by a rotor drum 53 of the rotor which is partly defined by the annular array of blades 48.

The present invention is described with reference to the above exemplary turbine engine having a single shaft or spool connecting a single, multi-stage compressor and a single, one or more stage turbine. However, it should be appreciated that the present invention is equally applicable to two or three shaft engines and which can be used for industrial, aero or marine applications.

The terms upstream and downstream refer to the flow direction of the airflow and/or working gas flow through the engine unless otherwise stated. The terms forward and rearward refer to the general flow of gas through the engine. The terms axial, radial and circumferential are made with reference to the rotational axis 20 of the engine.

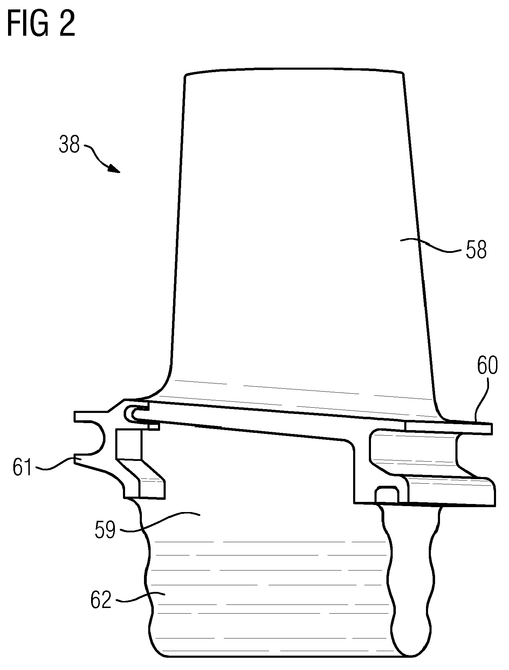

Fig.2 shows a gas turbine blade 38 according to the invention. The gas turbine blade 38 comprises an airfoil 58 and a root 59. The airfoil 58 is located in the hot gas path of the gas turbine 10 while the root 59 is arranged inside the rotor of the gas turbine 10 and shielded from the hot gas by a root platform 60. Herein the root platform 60 will not be considered to form part of the root 59.

The root 59 of the gas turbine blade 38 comprises an extended root 61 and root fixings 62 which serve to affix the gas turbine blade 38 to a rotor disc 36 in the gas turbine 10. Many different forms of root fixings are known in the field of gas turbine blades which may be applied to the present invention, e.g. dove tail fixings or fir-tree fixings.

As the airfoil 58 has to endure hot and corrosive gases a high content of chromium would be desirable. However, a more important aspect is that of mechanical integrity which requires the airfoil 58 to show very good creep resistance. For this reason a relatively low chromium content is chosen for the airfoil. Furthermore, the gas turbine blade is traditionally produced using casting techniques which result in single crystal, equiaxed or directionally solidified components exhibiting very good mechanical properties. Ceramic coatings are applied to the airfoils in order to protect them from corrosion. Since hot gas may also enter the space below the root platform 60, e.g. through gaps between root platforms 60 of adjacient gas turbine blades 38, the root 59 also needs such protection. However, such coatings are hard to apply and their integrity may be difficult to maintain during operation or even when inserting the rotor blade 38 into the rotor disc 36. For this reason the airfoil 58 and the root 59 will not be cast as a single piece. More particularly, according to the present invention the airfoil 58 will be cast without a root and the root 59 will then be built directly onto the airfoil 58 using selective laser melting (SLM) of powder layers deposited on the airfoil 58. This two-part manufacturing process allows choosing two different materials for the airfoil blade for good creep resistance on the one hand and for the root for good fatigue strength and corrosion resistance on the other. In this way a relatively low chromium content may be achieved for the airfoil section 58 of the gas turbine blade 38 and a relatively high chromium content for the root section 59.

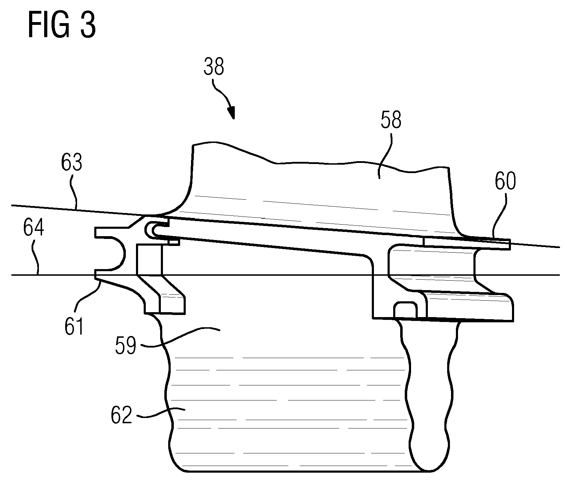

Fig. 3 shows a detailed view of the gas turbine blade 38 of Fig. 2. The same reference numerals describe the same features as in Fig. 2. The geometries produced by selective laser melting underlie some restrictions. For example, a cross section of a piece to be manufactured may not change rapidly from one layer to the next. For this reason the inventor propose to cast the root platform 60 together with the remaining parts of the gas turbine blade 38 which are directly exposed to the hot gas in the gas turbine 10. The root platform 60 is commonly the place where the cross sectional area of the turbine blade 38 in a plane tangential to the gas turbine rotor is the largest. This means that the root 59 can be built onto the root platform 60 easily as the cross sectional areas of the root 59 are likely to decrease in the layer depositing and melting process. For the most comfortable processing the cast airfoil 58 can be fixed in an upside-down position and the root 59 then be built onto the airfoil 58 using the SLM process.

It is desirable to locate the root 59 built from the second superalloy with the relatively high chromium content as closely to the hot gas path surface of the root platform 60 in order to enjoy the advantageous properties of the second superalloy to the fullest. A first transition line 63 indicates such a desirable position of the transition in Fig. 3. However, it may be necessary to place the transition from the cast airfoil 58 and first superalloy to the SLM-processed root 59 and second superalloy in a region with relatively little mechanical stress where cracking is less likely to occur and thus farther away from the first transition line 63. This region may be one with minimum curvature as highly radiussed portions of gas turbine blades are known to undergo more stress than relatively flat areas. In Fig. 3 a second transition line 64 is shown which shows an alternative for the transition from the first superalloy material to the second. The decision on where the transition will be made will generally depend on the individual geometry of the gas turbine blade 38. When designing a gas turbine rotor blade 38, the geometry could be adapted to accommodate for the transition from one material to the other.

The invention has an advantage in that it provides a method of producing a gas turbine blade and a gas turbine blade obtainable from the inventive method which consists of two section made from two different superalloys. In this way expensive coatings can be left away in all or at least part of the gas turbine blade root. Moreover, superior properties may be achieved in view of the conflicting requirements for the airfoil section and the root section of a gas turbine blade.

While the invention has been described by referring to preferred embodiments and illustrations thereof, it is to be understood that the invention is not limited to the specific form of the embodiments shown and described herein, and that many changes and modifications may be made thereto within the scope of the appended claims by one of ordinary skill in the art.

## Claims

1. A method of manufacturing a gas turbine blade (38) having an airfoil (58) and a root (59), **characterised by** a step of casting the airfoil (58) from a first nickel superalloy having a first chromium content and a step of building the root (59) on the cast airfoil (58) using selective laser melting of a plurality of layers of a powder of a second nickel superalloy having a second chromium content higher than the first chromium content.

2. The method of the preceding claim, wherein the step of casting the airfoil (58) includes casting an equiaxed, directionally solidified or single crystal airfoil (58).

3. The method of one of the preceding claims, further including a step of machining the root (59) of the gas turbine blade (38) to remove excess material.

4. The method of one of the preceding claims, wherein the selective laser melting further includes blending the first nickel superalloy and the second nickel superalloy and increasing a fraction of the second nickel superalloy in the blend while building the root (59).

5. The method of one of the preceding claims, wherein casting the airfoil (58) includes casting a root platform (60) and wherein building the root (59) includes building an extended root (61) and a root fixing (62) on the cast root platform (60).

6. The method of claims 4 and 5, wherein a portion of the root (59) between the root platform (60) and the extended root (61) is built from the blend of the first and the second nickel superalloys and wherein the extended root (61) and the root fixing (62) are built from the second nickel superalloy.

7. A gas turbine blade (38) comprising a cast airfoil (58) consisting of a first nickel superalloy having a first chromium content and a layer-deposited and selective laser melted root (59) comprising a second nickel superalloy having a second chromium content higher than the first chromium content.

8. The gas turbine blade (38) of the preceding claim, wherein the first chromium content is lower than 9 wt%.

9. The gas turbine blade (38) of one of the claims 7 or 8, wherein the second chromium content is at least 12 wt%.

10. The gas turbine blade (38) of one of the claims 7 through 9, wherein a radius of curvature reaches a minimum when crossing a transition region from the cast airfoil (58) to the root (59) of the gas turbine blade (38).
